# EUROPEAN PATENT SPECIFICATION

(11) **EP 2 089 773 B1**
(45) Date of publication and mention of the grant of the patent: **16.11.2011**
(21) Application number: 07856289.9
(22) Date of filing: 28.11.2007
(51) Int. Cl.: G03F 7/20, G02B 26/08

(54) **MOVABLE PHASE STEP MICRO MIRROR HAVING A MULTILAYER SUBSTRATE AND A METHOD FOR ITS MANUFACTURE**
BEWEGLICHER PHASENSCHRITT-MIKROSPIEGEL MIT EINEM MEHRSCHICHTIGEN SUBSTRAT UND VERFAHREN ZU SEINER HERSTELLUNG
MICRO-MIROIR À PAS DE PHASE MOBILE PRÉSENTANT UN SUBSTRAT MULTICOUCHE ET PROCÉDÉ DE FABRICATION CORRESPONDANT

(30) Priority: 28.11.2006 DE 102006057567
(43) Date of publication of application: 19.08.2009
(73) Proprietor: Micronic Mydata AB, 183 03 Täby (SE); Fraunhofer-Gesellschaft zur Förderung der angewandten Forschung e.V., 80686 München (DE)
(72) Inventor: SCHMIDT, Jan, Uwe, 01108 Dresden (DE); BAKKE, Thor, N-1366 Lysaker (NO); FRIEDRICHS, Martin, 01307 Dresden (DE); DÜRR, Peter, 01099 Dresden (DE)
(86) International application number: PCT/EP2007/010324
(87) International publication number: WO 2008/064879

(56) References cited:
- US-A- 5 789 264
- US-A1- 2005 073 737
- US-A1- 2005 128 565

## Description

The invention relates to micro-optical elements having a substrate, to a method for manufacturing these elements and their use. The substrates have at least one vertical step at an optically effective surface. They can be deflected, preferably electrostatically, around a rest position.

In addition to the increase in stiffness and strength against twisting and deflection, vertical steps can also achieve optical influences. A phase modulation of reflected or transmitted electromagnetic waves is possible, for instance. In this connection, a use for optical grids as well as for the anti-reflection coating of surfaces by grid-like interference structures is possible.

A particular application is represented by spatial light modulators (SLM) in the form of matrices which can be formed with a plurality of reflecting elements which can be deflected in a translatory or rotary manner. To be able to use phase contrast techniques, in particular for the exposure of masks or wafers, on an application of such elements in microlithography, it is necessary to realize mutually associated deflection states of the micro-optical elements for which electromagnetic radiation can be reflected with equal intensity, but with a phase position displaced by up to 180°.

US 2005/073737 A1 discloses an optical switch element, using an actuated mirror element and sacrificial layers in its manufacture. The actuated mirror can have its reflectivity set by an externally applied voltage through controlled destructive interference. The height of all occurring steps in the structure is defined by the height of the sacrificial layers. The created stack of optical layers includes an interstitial fixed layer disposed between a first fixed layer and a second fixed layer, to which additional layers can be added to increase the reflectivity of the element.

US 5 789 264 A relates to a method of manufacturing an array of thin-film actuated mirror elements by using a structured sacrificial layer. There, a "thin-film electrodisplacive member" is actuated by two enclosing electrodes. Also shown is an intermediate layer confined between layers.

Conventional SLMs in which the tiltable micromechanical elements have a planar surface are not able to do this. They achieve maximum reflectivity in the resting state. Radiation phase-shifted by 180° with respect to the electromagnetic radiation reflected in the resting state can admittedly demonstrated for the deflected element, but only with a fraction of the intensity. The phase contrast can thereby only be utilized with limitations. It has therefore been proposed for the solution of the problem to introduce an optical path difference of an odd number multiple of λ/4 (λ working wavelength) between the planoparallel reflecting zones separated by the axis of rotation, with the reflectivity of both zones having to remain approximately constant. In this case, the intensity reflected perpendicularly by the non-deflected element is minimal and increases to a maximum value of approximately half the incident intensity as the deflection increases. As demanded, the phase position of the reflected radiation differs by 180° for the two possible directions of the deflection.
A suitable micro-optical element and possibilities for its manufacture are described in WO 2005/057291 A1.

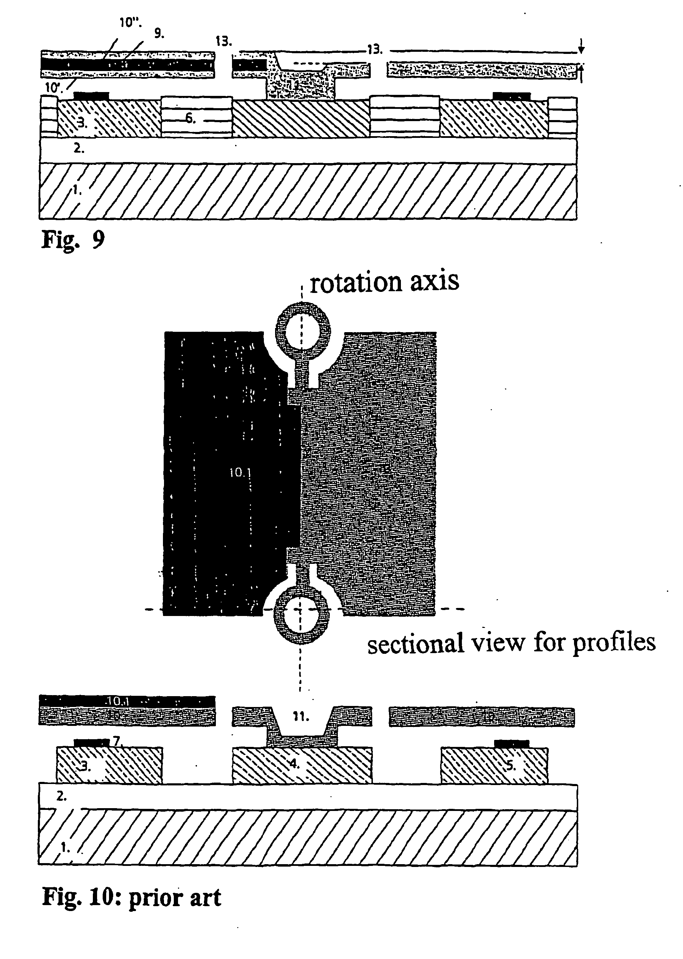

In this connection, conventionally transparent or semi-transparent layers are applied to a substrate and structured lithographically to form vertical steps, for example to achieve the mentioned path differences. A corresponding embodiment can be illustrated by Figure 10. Here, a substrate 10 is held by means of posts 11 at a carrier 1 and can be tilted around an axis of rotation. Electrodes 3 and 4 for an electrostatic deflection of the substrate 10 are present on the carrier 1. The vertical step has been made with an additional layer 10.1 formed by a material differing from the substrate material.

In the known solutions, problems occur, however, with respect to the planarity and to an increased temperature dependence.

In this context, a substrate without a coating can be reliably made available in planar form. If then, however, a coating takes place, the coated zone only is and remains planar in the desired form if no forces act at the interface to the coating. However, this is not the case as a rule since the layer stresses are not the same in the substrate and in the coating.

Since the thermal coefficients of expansion of the coating and the carrier are furthermore not identical, mechanical stresses are generated by temperature changes (e.g. caused by laser radiation) or by local temperature gradients (heat loss from circuits optionally integrated into the SLM) in the reflecting elements of the described kind, such as in a bimetallic strip, said stresses resulting in a bending or a deterioration of the planarity, whereby the imaging properties of the element deteriorate dramatically.

The different reflectivity in coated and uncoated zones can result in a locally different heating, and thus in high mechanical stresses, on operation with extremely short laser pulses. In the extreme case, even a delamination of the coating can occur as the case may be.

On the manufacture of micro-optical elements in question, it is necessary to observe a permanent and temperature-independent planarity as well as in particular to take account of further parameters with optically effective surfaces over their total area.

It is thus desired in micro-optical elements with phase-shifting properties to be able to set and observe the phase jump or jumps in an exactly reproducible manner and as homogeneously as possible. A homogeneous reflectivity or transparency should be able to be observed over the total optically effective surface.

A use should also be possible in the wavelength range of DUV radiation (in particular at 248 nm, 193 nm) VUV (157 nm) and EUV radiation (in particular at 13.4 nm).

Known and proven technologies should be made use of in the manufacture.

It is therefore the object of the invention to provide micro-optical elements which have vertical steps at optically effective surfaces, observe a homogeneous reflectivity at both sides of the vertical step(s) and maintain a high planarity permanently and independently of the temperature.

This object is solved in accordance with the invention by manufacturing methods for micro-optical elements having the features of claim 1. The object is further solved by micro-optical elements manufactured accordingly as described in claim 8. Advantageous uses are named by claim 21.

Advantageous embodiments and further developments of the invention can be achieved using features designated in the subordinate claims.

The micro-optical elements having a substrate in accordance with the invention are made such that at least one vertical step is formed at an optically effective surface.

The substrate with the vertical step(s) is formed with an intermediate layer which is confined symmetrically between at last two layers of the substrate, a first and a second substrate-forming layer. The layers should each consist of a homogeneous material or a nanolaminate.

Amorphous materials or materials which have a nanocrystalline structure should be used for the substrate.

In this connection, the optically effective upper side should be formed directly by the substrate. There is, however, the possibility of providing the total upper side with a suitable coating, for example a highly reflective coating. Such a coating should likewise be formed from a homogeneous material and have a constant layer thickness over the total surface to avoid the disadvantages of the solution known from WO 2005/057291 A1.

The layer can be reflective for the electromagnetic radiation. The material forming the coating should have a thermal coefficient of expansion which is at least almost the same as the substrate and a stress state adapted thereto, at least when it is only applied to the upper side.

Differences in the stress state and/or the thermal coefficient of expansion between substrate or the coating at its upper side can be largely compensated if a coating which is the same with respect to material, stress state and layer thickness is also formed at the lower side.

The, or optionally also the plurality, of vertical step(s) is/are formed directly at the substrate by means of the intermediate layer.

A layer stack consisting of a plurality of mutually connected individual layers should be called a nanolaminate here. A substrate formed with a nanolaminate can be formed with at least three individual thin layers (films) which differ in the manner of the material and/or in other layer properties. A nanolaminate can preferably be formed with layers made of at least two different materials or material mixtures. A structure of alternating thin layers of different materials can advantageously be selected for a substrate made as a nanolaminate in this connection, said structure being symmetrical to the center plane of the nanolaminate in the direction of the layer normal.
The vertical step(s) is/are made in locally different form in each case with an intermediate layer which should be formed in structured form on the first substrate forming layer and before forming the second substrate forming layer.

To achieve a phase-shifting effect already addressed, the at least one vertical step can have a step height of λ/4 or an odd number multiple of λ/4 of the selected working wavelength of an electromagnetic radiation. It can then advantageously be arranged at an axis of rotation and/or aligned parallel thereto at a micro-optical element pivotable around the axis of rotation.

The step height is set with the layer thickness of the intermediate layers(s).

The two substrate forming layers should have a constant and respectively equal layer thickness at least in zones with an optically effective surface in order to be able to observe symmetrical relationships.

As already indicated, more than two layers can be utilized for the substrate formation. In this context, however, a symmetrical structure should also be observed, i.e. respectively the same layers should be formed with respect to a symmetrical plane parallel to the optically effective surface at the mirror center in mirror symmetry at its two sides. One or more intermediate layers are then confined from both sides in the same manner by a plurality of layers or a nanolaminate. The respective individual layers should then have identical layer thicknesses and be made from the same materials.

To achieve a phase-shifting effect already addressed, the at least one vertical step can have a step height of λ/4 or an odd number multiple of λ/4 of the selected working wavelength of an electromagnetic radiation. It can then advantageously be arranged at an axis of rotation and/or aligned parallel thereto at a micro-optical element pivotable around the axis of rotation.

An optical grid can, however, also be made available with a plurality of vertical steps aligned parallel to one another and arranged at a suitable spacing from one another.

Electrodes can be arranged beneath the substrate, that is at the side disposed opposite an optically effective surface, and can be electrically controlled in a suitable manner to achieve a desired deflection/pivoting.

The substrate of the micro-optical element can be connected to a carrier by means of posts and can be kept at a spacing from said carrier. The substrate can be connected to the posts via elastically deformable spring elements. The spring elements can be made as torsion springs with a micro-optical element pivotable around an axis of rotation.

The carrier can preferably be a silicon substrate in the form of a wafer with an integrated CMOS circuit which is in turn electrically contacted to the already addressed electrodes.

A plurality of micro-optical elements in accordance with the invention can naturally also be made available in the form of an array.

A procedure can be followed in the manufacture such that a sacrificial layer is first formed on a surface of a carrier. The sacrificial layer should have a homogeneous layer thickness and only a slight surface roughness. It can preset the spacing of the substrate to the surface of the carrier after its later removal. Sacrificial layer(s) can be formed using amorphous silicon, silicon dioxide, photoresist, polyimide, TiₓAl_{y}, aluminum, MoₓSi_{y}N_{z}, TaₓSi_{y}N_{z}, CoₓSi_{y}N_{z}, SiₓN_{y}O_{z}, GeOₓ (where 0<x≤1, 0≤y, z<1) and/or molybdenum.

The substrate is then formed on or applied to the one sacrificial layer. The formation of the substrate can take place by forming two layers with an intermediate layer confined in the zone of vertical steps. This can be achieved by an evaporation known per se in vacuum, by a CVD process or also by sputtering.

The substrate can be made from silicon, aluminum, but also from another material which has the desired optical properties in the working wavelength, for example also from a nanolaminate. Aluminum can, for example, be used as a highly reflective material.
The intermediate layer(s) can be made, for example, using silicon oxide, molybdenum, molybdenum oxide, germanium or germanium oxide. An intermediate layer should, where possible, have its own stresses adapted to the substrate and be made from a material which can be selectively structured with respect to the substrate material. In addition, the material of the intermediate layer should be inert with respect to the etching processes which are used for the removal of the sacrificial layer and for the manufacture of the openings explained in the following.

After the formation of a substrate with a partly confined intermediate layer, openings are formed with the help of which a removal of the sacrificial layer can take place by etching processes and the substrate can thereby be exposed.

The substrates of the elements in accordance with the invention are admittedly differently structured in raised zones with their vertical steps with respect to sunk zones, but are formed from a single homogeneous material at the surface. A homogeneous reflectivity is thus given. The substrate is made symmetrical, which applies to the raised and to the sunk zones. In this connection, the substrate is made symmetrical to the center plane of the intermediate layer with respect to materials and layer thicknesses, whereby a thermal compensation is achieved and a change in the planarity on temperature fluctuations is avoided. A thermal compensation can thus be achieved and a change in the planarity on temperature fluctuations can be avoided. When the process parameters are observed in the forming and removal of the layers, the inherent tension in the identically structured parts of the substrate disposed at both sides of the symmetry plane and associated with one another can be set in each case to the same value so that, due to the observed symmetry, no deformations occur as a result of the different inherent stresses for different layer materials. Furthermore, it is achieved by the symmetrical design that the planarity of the elements reacts relatively non-sensitively to slight changes in the layer properties, for example due to target wear in a sputter coating, since the changes act equally at both sides of the symmetry plane and thus compensate one another.

Optionally present gradients of the inherent stress in layers can break the symmetry of the element and result in a worse planarity. They can, however, be minimized by a matched process management.

The invention can advantageously be used for the direct exposure of wafers, the manufacture of masks, exposure of circuit boards, the projection of images, the modification of imaging properties of optical systems, as an optical grid or for applications in adaptive optics.

The invention will be explained in more detail by way of example in the following.

There are shown:
Figures 1 to 9, successively, the manufacture of an example of a micro-optical element in accordance with the invention, as a phase shifter having a vertical step, which is pivotable about an axis of rotation; and
Figure 10 an example of the prior art.

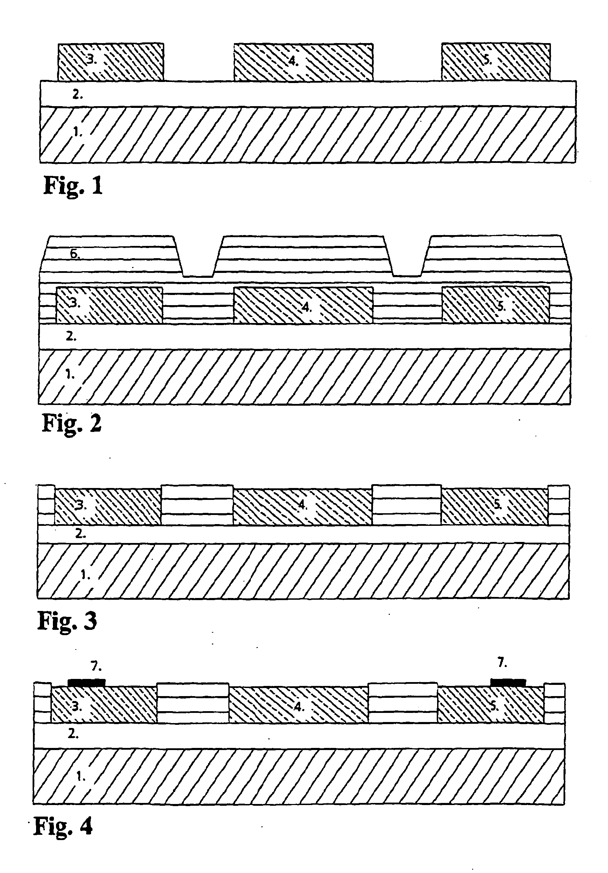

A carrier 1 is used for the manufacture of an example of a micro-optical element in accordance with the invention. Said carrier is a silicon substrate having a fixedly wired electrode array or an integrated CMOS circuit. The latter is contacted via electrically conductive connections to a counterelectrode 3, a substrate electrode 4 and an address electrode 5. The named connections are embedded in a dielectric passivation layer 2 which is formed from silicon dioxide and/or aluminum oxide (cf. Figure 1).

In CVD technology, for example, a dielectric passivation layer 6 is applied thereon (cf. Figure 2). It is later smoothed, for example by chemically mechanical polishing and is partly removed in this process (cf. Figure 3). It forms an electrical insulation between the electrodes 3, 4 and 5. Stoppers 7 can then be deposited as layers on electrodes and structured. They can avoid an electrical short circuit between the substrate 10 and the electrodes 3, 4 and 5 in the event of deflections accidentally occurring which are too high (cf. Figure 4).

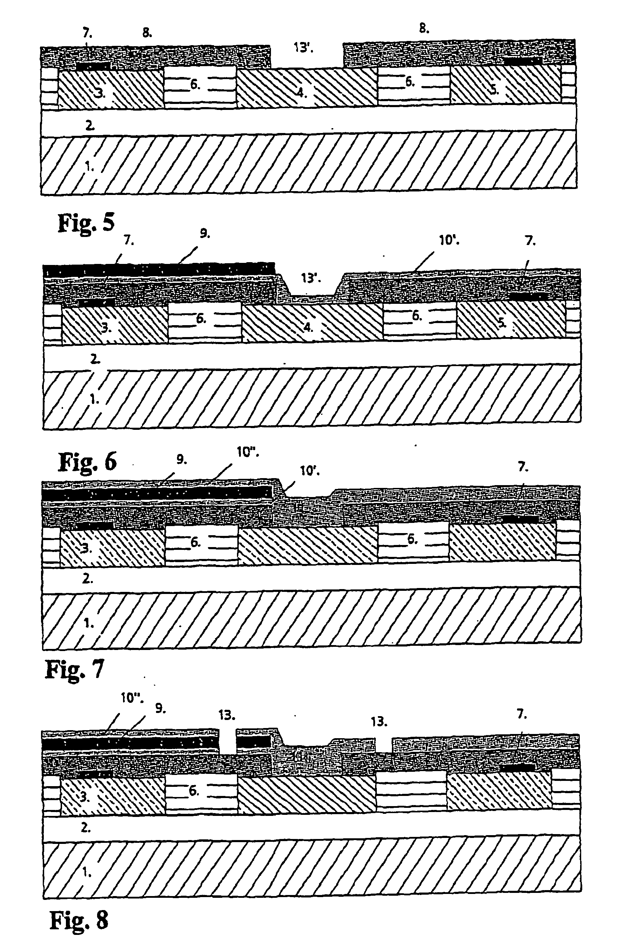

A first sacrificial layer 8 is deposited thereon in CVD technology or sputtering technology or by spin coating of a liquid precursor (cf. Figure 5). They can, for example, be made of amorphous silicon, silicon oxide or of a polymer (e.g. polyimide). It determines the later spacing between the substrate 10 and the electrodes 3, 4 and 5 and thus also defines the voltage deflection characteristic on the electrical operation with deflection of the micro-optical element.

In the example, a first substrate forming layer 10' is deposited onto the sacrificial layer 8 and into the openings 13' after the formation of openings 13' in the sacrificial layer 8 which are provided for a formation of posts 11. This layer 10' should have a homogeneous layer thickness at least in zones which later have an optically effective surface.

An intermediate layer 9 is then formed by a homogeneous deposition and a subsequent structuring on the surface of the first substrate forming layer 10' in structured form, that is on zones at which vertical steps should be formed. The intermediate layer 9 is deposited with a layer thickness which corresponds to an odd number multiple of λ/4 of the preset working wavelength of the electromagnetic radiation (cf. Figure 6).

The arrangement and dimension with step height of the vertical step(s) are already fixed at this time.

The intermediate layer 9 can be formed from silicon oxide, molybdenum, molybdenum oxide, germanium or germanium oxide.

The arrangement and dimension with step height of the vertical step(s) are already fixed at this time.

A second substrate forming layer 10", as shown in Figure 7, is formed on the surface structured in this manner, that is, both on zones with an intermediate layer 9 and on surface zones which are only formed with a first substrate forming layer 10'. This second layer 10" should have the same layer thickness as the first substrate forming layer 10' for the observation of symmetry. The intermediate layer 9 is thus confined symmetrically in the substrate material in the zone of the vertical steps and in so doing defines the step height of the vertical step.

Openings 13 are formed by etching through the substrate 10 and the intermediate layer 9, as can be seen from Figure 8. In this connection, openings 13 should preferably be formed in the zone of posts 11. The substrate 10 is then held at the carrier 1 using posts 11 via spring elements not visible in the cross-section shown.

In an isotropic dry etching process, the sacrificial layer 8 between the substrate 10 and the carrier 1 is then completely removed and the substrate 10 is exposed, as is shown as a completely manufactured micro-optical element in Figure 9.

## Claims

1. A method for manufacturing a micro-optical element capable of maintaining a high planarity permanently and independently of the temperature having a substrate (10) at wich at least one vertical step is formed at and optically effective surface, where the micro-optical element is configured to be deflected in a translatory or rotary manner, with respect to a carrier being connected to the micro-optical element,
***characterized by** the step of*
forming the vertical step(s) with a structured intermediate layer(9) confined symmetrically between at least two layers (10', 10") of the substrate (10), wherein each layer (10', 10") consists of a homogeneous material or of a nanolaminate, and the at least two layers (10',10") have the same layer thickness, and wherein the layer thickness of the intermediate layer (9) corresponds to the step height of the vertical step(s).

2. A method in accordance with claim 1, wherein a sacrificial layer (8) is formed on a carrier (1) ;
at least one first substrate forming layer (10') of the at least two layers (10', 10") of the substrate (10) is formed above the sacrificial layer (8) and the intermediate layer (9) is formed with a layer thickness which corresponds to the step height of the vertical steps(s) on this/these first layer(s) (10) in the zone of one or more vertical step(s) to be formed;
subsequently thereto at least one second substrate forming layer (10") of the at least two layers (10',10") of the substrate (10) is formed on the entire surface; and
subsequently, openings (13) are formed through the substrate (10) through which a removal of the sacrificial layer (8) takes place by etching processes.

3. A method in accordance with one of claims 1 or 2,
***characterized in that***
openings (13') are formed in the sacrificial layer (8) in zones in which posts (11) should be formed before the first substrate forming layer(s) (10') is/are applied.

4. A method in accordance with one of claims 1 to 3,
***characterized in that***
the intermediate layer (9) is made with a layer thickness which corresponds to λ/4 or to an odd number multiple of λ/4 of a set wavelength.

5. A method in accordance with one of claims 1 to 4,
***characterized in that***
the sacrificial layer (8) is made with AlₓTi_{y}, SiₓO_{y} , MOₓO_{y}, GeₓO_{y} (where 0<x≤1, 0≤y≤1) and/or with a polymer.

6. A method in accordance with one of claims 1 to 5,
***characterized in that***
a passivation layer (6) is applied to the carrier (1) having electrodes (3, 4, 5), said passivation layer electrically insulating the electrodes (3, 4, 5) and then being removed again until the exposing of the electrodes (3, 4, 5).

7. A method in accordance with one of claims 1 to 6,
***characterized in that***
stoppers (7) of a dielectric or high-ohm material are applied to electrodes (3, 4, 5).

8. A micro-optical element manufactured by a method according to one of claims 1 to 7.

9. An element in accordance with claim 8,
***characterized in that***
the intermediate layer(s) (9) forming the vertical step(s) have a layer thickness of λ/4 or of an odd number multiple of λ/4 of a set working wavelength.

10. An element in accordance with one of claims 8 to 9,
***characterized in that***
an edge of a vertical step is present at an axis of rotation of the element and/or is aligned parallel thereto.

11. An element in accordance with one of claims 8 to 10,
***characterized in that***
an optical grid is formed using vertical steps.

12. An element in accordance with one of claims 8 to 11,
***characterized in that***
the optically effective surface is formed with a reflective layer formed on the substrate (10).

13. An element in accordance with one of claims 8 to 12,
***characterized in that***
the substrate (10) with the intermediate layer (9) locally embedded therein is enclosed at its upper side and lower side by two layers which are each formed from the same material.

14. An element in accordance with one of claims 8 to 14,
***characterized in that***
the material(s) forming the substrate (10) have an amorphous or nanocrystalline structure.

15. An element in accordance with one of claims 8 to 15,
***characterized in that***
electrodes (3, 4, 5) for a deflection of the element are arranged below the substrate (10).

16. An element in accordance with one of claims 8 to 16,
***characterized in that***
the substrate (10) is connected by means of posts (11) and/or by means of spring elements to a carrier (1) and is arranged at a spacing thereto.

17. An element in accordance with one of claims 8 to 17,
***characterized in that***
the carrier (1) is made as a silicon substrate with an integrated CMOS circuit or with an array of fixedly wired externally controllable electrodes.

18. An element in accordance with one of claims 8 to 18,
***characterized in that***
the substrate (10) is formed from AlₓTi_{y}, MoₓSi_{y} N_{z}, TaₓSi_{y}N_{z}, a-Si, COₓSi_{y}N_{z}, SiₓN_{y}O_{z}, GeₓO_{y} (where 0<x≤1, 0≤y≤1, 0≤z≤1).

19. An element in accordance with one of claims 8 to 19,
***characterized in that***
the intermediate layer(s) (9) is/are formed from AlₓTi_{y}, SiₓO_{y} , MoOₓ, GeOₓ, MoₓSi_{y}N_{z}, TaₓSi_{y}N_{z}, a-Si (where 0<x≤1, 0≤y≤1, 0≤z≤1).

20. An element in accordance with one of claims 8 to 20,
***characterized in that***
the stack of substrate forming layers (10') and (10"), intermediate layer (9) and/or additional coatings has mirror symmetry to the center plane of the element, parallel to the optically active surface, at the upper side or lower side of the element.

21. Use of an element in accordance with one of the claims 8 to 21 for the direct exposure of wafers, the manufacture of masks, the manufacture of masks for wafer exposure, exposure of circuit boards, the projection of images, the modification of image properties of optical systems, applications in adaptive optics or as an optical grid.

## Patentansprüche

1. Verfahren zum Herstellen eines mikrooptischen Elements, das zum permanenten und von der Temperatur unabhängigen Aufrechterhalten einer hohen Planarität imstande ist, mit einem Substrat (10), bei dem zumindest eine vertikale Stufe an einer optisch wirksamen Oberfläche gebildet ist, wobei das mikrooptische Element so konfiguriert ist, dass es translatorisch oder drehend in Bezug auf einen Träger, der mit dem mikrooptischen Element verbunden ist, abgelenkt wird,
**gekennzeichnet durch** den Schritt
der Bildung der vertikalen Stufe(n) mit einer strukturierten Zwischenschicht (9), die symmetrisch zwischen zumindest zwei Schichten (10', 10") des Substrates (19) begrenzt ist, wobei jede Schicht (10', 10") aus einem homogenen Material oder aus einem Nanolaminat besteht und die zumindest zwei Schichten (10', 10") dieselbe Schichtdicke haben, und wobei die Schichtdicke der Zwischenschicht (9) der Stufenhöhe der vertikalen Stufe(n) entspricht.

2. Verfahren nach Anspruch 1, wobei eine Opferschicht (8) auf einem Träger (1) gebildet ist;
zumindest eine erste Substratbildungsschicht (10') der zumindest zwei Schichten (10', 10") des Substrates (10) über der Opferschicht (8) gebildet ist und die Zwischenschicht (9) mit einer Schichtdicke gebildet ist, die der Stufenhöhe der vertikalen Stufe(n) auf dieser/diesen ersten Schicht(en) (10) in der Zone entspricht, in der eine oder mehrere vertikale Stufe(n) zu bilden sind;
anschließend daran zumindest eine zweite Substratbildungsschicht (10") der zumindest zwei Schichten (10', 10") des Substrates (10) auf der gesamten Oberfläche gebildet wird; und
anschließend Öffnungen (13) durch das Substrat (10) gebildet werden, durch die eine Entfernung der Opferschicht (8) durch Ätzprozesse erfolgt.

3. Verfahren nach einem der Ansprüche 1 oder 2, **dadurch gekennzeichnet, dass**
Öffnungen (13') in der Opferschicht (8) in Zonen gebildet werden, in welchen Pfosten (11) gebildet werden sollen, bevor die erste(n) Substratbildungsschicht(en) (10') aufgetragen wird (werden).

4. Verfahren nach einem der Ansprüche 1 bis 3, **dadurch gekennzeichnet, dass**
die Zwischenschicht (9) mit einer Schichtdicke hergestellt wird, die λ/4 oder einem ungeraden Vielfachen von λ/4 einer eingestellten Wellenlänge entspricht.

5. Verfahren nach einem der Ansprüche 1 bis 4, **dadurch gekennzeichnet, dass**
die Opferschicht (8) mit AlₓTi_{y}, SiₓO_{y,} MoₓO_{y}, GeₓO_{y} (wobei 0<x≤1, 0≤y≤1) und/oder mit einem Polymer hergestellt ist.

6. Verfahren nach einem der Ansprüche 1 bis 5, **dadurch gekennzeichnet, dass**
eine Passivierungsschicht (6) auf den Träger (1) mit Elektroden (3, 4, 5) aufgetragen wird, wobei die Passivierungsschicht die Elektroden (3, 4, 5) elektrisch isoliert und dann wieder bis zur Exposition der Elektroden (3, 4, 5) entfernt wird.

7. Verfahren nach einem der Ansprüche 1 bis 6, **dadurch gekennzeichnet, dass**
Stopper (7) aus einem dielektrischen oder hochohmigen Material auf die Elektroden (3, 4, 5) aufgebracht werden.

8. Mikrooptisches Element, das durch ein Verfahren nach einem der Ansprüche 1 bis 7 hergestellt wird.

9. Element nach Anspruch 8, **dadurch gekennzeichnet, dass**
die Zwischenschicht(en) (9), die die Vertikale(n) Stufe(n) bildet (bilden), eine Schichtdichte von λ/4 oder einem ungeraden Vielfachen von λ/4 einer eingestellten Arbeitswellenlänge hat (haben).

10. Element nach einem der Ansprüche 8 bis 9, **dadurch gekennzeichnet, dass**
eine Kante einer vertikalen Stufe bei einer Drehachse des Elements vorhanden ist und/oder parallel zu dieser ausgerichtet ist.

11. Element nach einem der Ansprüche 8 bis 10, **dadurch gekennzeichnet, dass**
ein optisches Gitter unter Verwendung vertikaler Stufen gebildet ist.

12. Element nach einem der Ansprüche 8 bis 12, **dadurch gekennzeichnet, dass**
die optisch wirksame Oberfläche mit einer reflektierenden Schicht gebildet ist, die auf dem Substrat (10) gebildet ist.

13. Element nach einem der Ansprüche 8 bis 12, **dadurch gekennzeichnet, dass**
das Substrat (10) mit der Zwischenschicht (9), die lokal darin eingebettet ist, an seiner oberen Seite und unteren Seite von zwei Schichten eingeschlossen ist, die jeweils aus demselben Material gebildet sind.

14. Element nach einem der Ansprüche 8 bis 13, **dadurch gekennzeichnet, dass**
das Material (die Materialien), das (die) das Substrat (10) bildet (bilden), eine amorphe oder nanokristalline Struktur hat (haben).

15. Element nach einem der Ansprüche 8 bis 14 **dadurch gekennzeichnet, dass**
Elektroden (3, 4, 5) für eine Ablenkung des Elements unter dem Substrat (10) angeordnet sind.

16. Element nach einem der Ansprüche 8 bis 15, **dadurch gekennzeichnet, dass**
das Substrat (10) mit Hilfe von Pfosten (11) und/oder mit Hilfe von Federelementen mit einem Träger (1) verbunden ist und mit Abstand zu diesem angeordnet ist.

17. Element nach einem der Ansprüche 8 bis 16, **dadurch gekennzeichnet, dass**
der Träger (1) als ein Siliziumsubstrat mit einer integrierten CMOS-Schaltung oder mit einer Gruppe von festverdrahteten, extern steuerbaren Elektroden hergestellt ist.

18. Element nach einem der Ansprüche 8 bis 17, **dadurch gekennzeichnet, dass**
das Substrat (10) aus AlₓTi_{y}, MoₓSi_{y}N_{z}, TaₓSi_{y}N_{z}, a-Si, CoₓSi_{y}N_{z}, SiₓN_{y}O_{z}, GeₓO_{y} (wobei 0<x≤1, 0≤y≤1, 0≤z≤1) gebildet ist.

19. Element nach einem der Ansprüche 8 bis 18, **dadurch gekennzeichnet, dass**
die Zwischenschicht (en) (9) aus AlₓTi_{y}, SiₓO_{y}, MoOₓ, GeOₓ, MoₓSi_{y}N_{z}, TaₓSi_{y}N_{z}, a-Si (wobei 0<x≤1, 0≤y≤1, 0≤z≤1) gebildet ist (sind).

20. Element nach einem der Ansprüche 8 bis 19, **dadurch gekennzeichnet, dass**
der Stapel aus Substratbildungsschichten (10') und (10"), Zwischenschicht (9) und/oder zusätzlichen Beschichtungen Spiegelsymmetrie zu der Mittelebene des Elements, parallel zu der optisch aktiven Oberfläche, an der oberen Seite und unteren Seite des Elements hat.

21. Verwendung eines Elements nach einem der Ansprüche 8 bis 20 für die direkte Belichtung von Wafern, die Herstellung von Masken, die Herstellung von Masken zur Waferbelichtung, Belichtung von Leiterplatten, die Projektion von Bildern, die Modifizierung von Bildeigenschaften optischer Systeme, Anwendungen in der adaptiven Optik oder als optisches Gitter hat.

## Revendications

1. Procédé de fabrication d'un élément micro-optique capable de maintenir une grande planéité en permanence et indépendamment de la température, ayant un substrat (10) auquel au moins un pas vertical est formé à une surface optiquement efficace, où l'élément micro-optique est configuré pour être dévié en translation ou en rotation par rapport à un support lié à l'élément micro-optique,
**caractérisé par** l'étape suivante :
la formation de l'au moins un pas vertical avec une couche intermédiaire structurée (9) confinée symétriquement entre au moins deux couches (10', 10") du substrat (10), dans lequel chaque couche (10', 10") se compose d'un matériau homogène ou d'un nano-stratifié, et les au moins deux couches (10', 10") ont la même épaisseur de couche, et dans lequel l'épaisseur de couche de la couche intermédiaire (9) correspond à la hauteur de pas de l'au moins un pas vertical.

2. Procédé selon la revendication 1, dans lequel une couche de sacrifice (8) est formée sur un support (1) ;
au moins une première couche de formation de substrat (10') des au moins deux couches (10', 10") du substrat (10) est formée au-dessus de la couche de sacrifice (8) et la couche intermédiaire (9) est formée avec une épaisseur de couche qui correspond à la hauteur de pas de l'au moins un pas vertical sur l'au moins une première couche (10) dans la zone de l'au moins un pas vertical à former ;
après cela, au moins une deuxième couche de formation de substrat (10") des au moins deux couches (10', 10") du substrat (10) est formée sur toute la surface ; et
après cela, il est formé dans le substrat (10) des ouvertures (13) à travers lesquelles la couche de sacrifice (8) est enlevée par des procédés de mordançage.

3. Procédé selon la revendication 1 ou 2, **caractérisé en ce que** :
des ouvertures (13') sont formées dans la couche de sacrifice (8) dans des zones dans lesquelles des montants (11) doivent être formés avant d'appliquer l'au moins une première couche de formation de substrat (10').

4. Procédé selon l'une quelconque des revendications 1 à 3, **caractérisé en ce que**
la couche intermédiaire (9) est constituée d'une épaisseur de couche correspondant à λ/4 ou à un multiple impair de λ/4 d'une longueur d'onde réglée.

5. Procédé selon l'une quelconque des revendications 1 à 4, **caractérisé en ce que** :
la couche de sacrifice (8) est constituée de AlₓTi_{y}, SiₓO_{y}, MoₓO_{y}, GeₓO_{y} (où 0 < x ≤ 1, 0 ≤ y ≤ 1) et/ou d'un polymère.

6. Procédé selon l'une quelconque des revendications 1 à 5, **caractérisé en ce que** :
une couche de passivation (6) est appliquée sur le support (1) ayant des électrodes (3, 4, 5), ladite couche de passivation isolant électriquement les électrodes (3, 4, 5) puis étant enlevée jusqu'à l'exposition des électrodes (3, 4, 5).

7. Procédé selon l'une quelconque des revendications 1 à 6, **caractérisé en ce que** :
des butées (7) d'un matériau diélectrique ou de grande résistance ohmique sont appliquées sur les électrodes (3, 4, 5).

8. Elément micro-optique fabriqué par un procédé selon l'une quelconque des revendications 1 à 7.

9. Elément selon la revendication 8, **caractérisé en ce que** :
l'au moins une couche intermédiaire (9) formant l'au moins un pas vertical a une épaisseur de couche de λ/4 ou d'un multiple impair de λ/4 d'une longueur d'onde de travail réglée.

10. Elément selon l'une quelconque des revendications 8 et 9, **caractérisé en ce que** :
un bord d'un pas vertical est présent à un axe de rotation de l'élément et/ou est aligné parallèlement à celui-ci.

11. Elément selon l'une quelconque des revendications 8 à 10, **caractérisé en ce que** :
une grille optique est formée en utilisant des pas verticaux.

12. Elément selon l'une quelconque des revendications 8 à 11, **caractérisé en ce que** :
la surface optiquement efficace est constituée d'une couche réflective formée sur le substrat (10).

13. Elément selon l'une quelconque des revendications 8 à 12, **caractérisé en ce que** :
le substrat (10) auquel la couche intermédiaire (9) est localement intégrée est enclos à son côté supérieur et à son côté inférieur par deux couches constituées du même matériau.

14. Elément selon l'une quelconque des revendications 8 à 13, **caractérisé en ce que** :
l'au moins un matériau constituant le substrat (10) présente une structure amorphe ou nanocristalline.

15. Elément selon l'une quelconque des revendications 8 à 14, **caractérisé en ce que** :
des électrodes (3, 4, 5) pour une déviation de l'élément sont agencées au-dessous du substrat (10).

16. Elément selon l'une quelconque des revendications 8 à 15, **caractérisé en ce que** :
le substrat (10) est lié au moyen de montants (11) et/ou au moyen d'éléments de ressort à un support (1) et est agencé à un espacement de celui-ci.

17. Elément selon l'une quelconque des revendications 8 à 16, **caractérisé en ce que** :
le support (1) est constitué d'un substrat de silicium avec un circuit CMOS intégré ou avec un réseau d'électrodes pouvant être commandées de l'extérieur et dotées d'un câblage fixe.

18. Elément selon l'une quelconque des revendications 8 à 17, **caractérisé en ce que** :
le substrat (10) est constitué de AlₓTi_{y}, MoₓSi_{y}N_{z}, TaₓSi_{y}N_{z}, a-Si, CoₓSi_{y}N_{z}, SiₓN_{y}O_{z}, GeₓO_{y} (où 0 < x ≤ 1, 0 ≤ y ≤ 1, 0 ≤ z ≤ 1).

19. Elément selon l'une quelconque des revendications 8 à 18, **caractérisé en ce que** :
l'au moins une couche intermédiaire (9) est constituée de AlₓTi_{y}, SiₓO_{y}, MoOₓ, GeOₓ, MoₓSi_{y}N_{z}, TaₓSi_{y}N_{z}, a-Si (où 0 < x ≤ 1, 0 ≤ y ≤ 1, 0 ≤ z ≤ 1).

20. Elément selon l'une quelconque des revendications 8 à 19, **caractérisé en ce que** :
la pile de couches de formation de substrat (10', 10"), de couche intermédiaire (9) et/ou de revêtements supplémentaires a une symétrie de miroir par rapport au plan central de l'élément, parallèlement à la surface optiquement active, au côté supérieur ou au côté inférieur de l'élément.

21. Utilisation d'un élément selon l'une quelconque des revendications 8 à 20, pour l'exposition directe de tranches, la fabrication de masques, la fabrication de masques pour l'exposition de tranches, l'exposition de cartes de circuits, la projection d'images, la modification de propriétés d'images de systèmes optiques, des applications d'optique adaptative ou en tant que grille optique.
